# FASCICULE DE BREVET EUROPEEN

(11) **EP 0 942 492 B1**
(45) Date de publication et mention de la délivrance du brevet: **09.07.2003**
(21) Numéro de dépôt: 99201075.1
(22) Date de dépôt: 07.04.1997
(51) Int. Cl.: G06K 7/00, H01R 13/514, H01R 12/04, H01R 12/16

(54) **Boîtier de raccordement électronique, à un ordinateur individuel, équipé d'un connecteur pour une carte à puce**
Gehäuse zur elektronischen Verbindung an einen Computer ausgerüstet mit einem IC-Karten-Verbinder
Housing for electronic connection to a computer equipped with an IC card connector

(30) Priorité: 18.04.1996 FR 9604842
(43) Date de publication de la demande: 15.09.1999
(62) Demande divisionnaire de: 97923269.1
(73) Titulaire: ITT MANUFACTURING ENTERPRISES, INC., Wilmington, Delaware 19801 (US)
(72) Inventeur: Brichaud, Hervé, 39100 Dole (FR); Biermann, Werner, 73650 Winterbach (DE)
(74) Mandataire: Kohn, Philippe

(56) Documents cités:
- EP-A- 0 274 288
- EP-A- 0 480 334
- DE-A- 4 138 342
- DE-U- 29 505 678

## Description

La présente invention concerne un boîtier de raccordement électronique, notamment pour un ordinateur individuel.

L'invention concerne plus particulièrement un boîtier de raccordement en forme générale de carte qui peut être introduit dans une fente de forme complémentaire de l'ordinateur en vue d'établir un ou plusieurs raccordements entre par exemple l'ordinateur et des unités périphériques.

Dans le cas de son application aux ordinateurs personnels, un tel boîtier de raccordement électronique, aussi appelé "carte PC" répond désormais à une standardisation correspondant à la norme PCMCIA ("Personal Computer Memory Card International Association") qui concerne notamment les dimensions extérieures du boîtier de raccordement afin de permettre son insertion dans n'importe quel ordinateur personnel comportant une fente d'introduction dont les dimensions sont complémentaires et correspondent à la norme PCMCIA.

Ainsi, le boîtier de raccordement électronique en.forme générale de carte est du type comportant une coquille métallique, qui peut notamment être réalisée en deux parties, à parois principales planes parallèles et opposées, supérieure et inférieure, qui délimitent entre elles une cavité, ouverte à ses deux extrémités longitudinales opposées et délimitée transversalement par deux parois latérales opposées conformées en forme de rails de guidage du boîtier, à l'intérieur de laquelle est agencée une plaque intermédiaire, notamment une plaque à circuit imprimé, qui s'étend sensiblement à mi-hauteur entre les faces internes en vis-à-vis des parois principales et parallèlement à ces dernières.

La plaque intermédiaire à circuit imprimé peut porter différents composants électroniques et, à ses extrémités longitudinales opposées, des connecteurs de raccordement qui débouchent de part et d'autre dans les extrémités longitudinales ouvertes du boîtier de manière à assurer le raccordement de ce dernier avec l'ordinateur en ce qui concerne le connecteur agencé à l'extrémité interne du boîtier qui est introduite dans l'ordinateur et, le cas échéant, à un autre appareil ou une ligne de communication en ce qui concerne l'autre connecteur agencé à l'extrémité longitudinale externe du boîtier qui peut, par exemple, recevoir une prise de raccordement à une ligne téléphonique.

Pour certaines applications, et par exemple pour autoriser un utilisateur d'un ordinateur personnel à accéder à un réseau de télécommunications, il est apparu nécessaire de pouvoir associer le boîtier de raccordement électronique à une carte à circuit(s) intégré(s) à contact, aussi appelée communément carte à puce, cette dernière comportant des informations en mémoire qui sont exploitées par le boîtier de raccordement et l'ordinateur associé lors de la connexion de l'ordinateur avec un réseau de télécommunications.

Ce principe d'autorisation d'accès d'un utilisateur titulaire d'une carte à puce est couramment appliqué dans le domaine de la radiotéléphonie, la carte à puce correspondant à l'une ou l'autre des deux normes dimensionnelles, et le plus souvent à la carte miniature, aussi appelée carte "MICRO SIM", dont l'encombrement est particulièrement réduit.

La connexion d'une telle carte à puce avec un quelconque dispositif électronique d'exploitation de données qu'elle contient est couramment assurée par l'intermédiaire d'un connecteur de conception générale connue qui comporte un support en matériau isolant comportant un logement ouvert dans sa face supérieure qui reçoit la carte à puce comportant sur sa face principale des plages conductrices qui coopèrent avec les extrémités de contact d'éléments de contact électrique agencées dans le fond du logement du support isolant du connecteur.

Il a déjà été proposé d'associer un tel connecteur à un boîtier de raccordement PCMCIA mais les conceptions connues à ce jour ont pour principal inconvénient d'affecter de manière importante la structure du boîtier en en réduisant ainsi de manière inacceptable la rigidité et les caractéristiques de blindage électronique que la coquille métallique doit impérativement assurer pour protéger les composants internes au boîtier de raccordement électronique.

On connaît du document DE-U-29.505.678 un boîtier de raccordement électronique au format carte "PCMCIA" pour connecter une carte à circuits intégrés, ou carte à puce, à contact à un appareil électronique comportant une fente complémentaire au format "PCMCIA". Ce boitier divulgue les caractéristiques du préambule de la revendication 1.

On connaît par ailleurs du document DE-A-4.138.432 un connecteur électrique pour une carte à puce pouvant par exemple être intégré dans un boîtier électronique du type mentionné ci-dessus.

L'invention a pour but de proposer une nouvelle conception d'un boîtier de raccordement électronique de type mentionné précédemment grâce à laquelle, le connecteur peut notamment être agencé sur l'une ou l'autre des faces opposées de la plaque à circuit imprimé, notamment lorsqu'elle partage la cavité en deux parties de hauteurs inégales.

Dans ce but, l'invention , propose un boîtier de raccordement électronique tel que défini à la revendication 1.

Des modes de réalisation préférés de l'invention sont définis aux revendications dépendantes.

Selon d'autres caractéristiques préférentielles de l'invention :
- le support en matériau isolant comporte un logement ouvert dans sa face supérieure, délimité par deux bords parallèles à la direction d'introduction de la carte et transversalement par au moins un bord arrière et qui reçoit au moins en partie la carte comportant sur sa face principale inférieure des plages conductrices qui coopèrent avec les extrémités de contact d'éléments de contact électrique, agencées dans le fond du logement du support, lorsque la carte (C) est dans sa position de raccordement dans laquelle son bord transversal arrière est en butée contre le bord transversal arrière du logement, et la face interne en vis à vis de la paroi principale supérieure est adjacente à la face supérieure du support du connecteur ;
- la direction d'introduction de la carte dans le boîtier est perpendiculaire à la direction longitudinale du boîtier, et la fente d'introduction est formée au moins en partie dans l'une des parois latérales du boîtier ;
- le boîtier de raccordement comporte des moyens d'extraction de la carte hors du boîtier ;
- les moyens d'extraction de la carte comportent une entaille formée dans la paroi principale supérieure du boîtier et qui s'étend parallèlement à la direction d'introduction pour permettre d'agir sur la carte en vue de provoquer son coulissement à l'intérieur du logement dans le sens correspondant à son extraction ;
- l'entaille s'étend au moins en partie au droit du bord transversal arrière de la carte lorsque cette dernière est en position introduite pour permettre l'introduction d'un outil d'extraction qui coopère avec le bord transversal arrière de la carte.

D'autres caractéristiques et avantages de l'invention apparaîtront à la lecture de la description détaillée qui suit pour la compréhension de laquelle on se reportera aux dessins annexés dans lesquels :
- la figure 1 est une vue en perspective éclatée des principaux composants d'un boîtier de raccordement réalisé conformément aux enseignements de l'invention ;
- la figure 2 est une vue de détail en perspective du boîtier illustré à la figure 1 qui illustre à plus grande échelle l'agencement de la fente d'introduction de la carte dans le boîtier ;
- la figure 3 est une vue de dessus d'un autre mode de réalisation du connecteur ;
- la figure 4 est une vue latérale de droite du connecteur illustré à la figure 3 ;
- la figure 5 est une vue de dessous du connecteur illustré à la figure 3 ;
- la figure 6 est un schéma illustrant des découpes prévues dans la plaque à circuit imprimé du boîtier de raccordement pour recevoir le connecteur illustré aux figures 3 à 5 ; et
- la figure 7 est une vue de dessous de la plaque à circuit imprimé de la figure 6 avec le connecteur en place sur la carte à circuit imprimé.

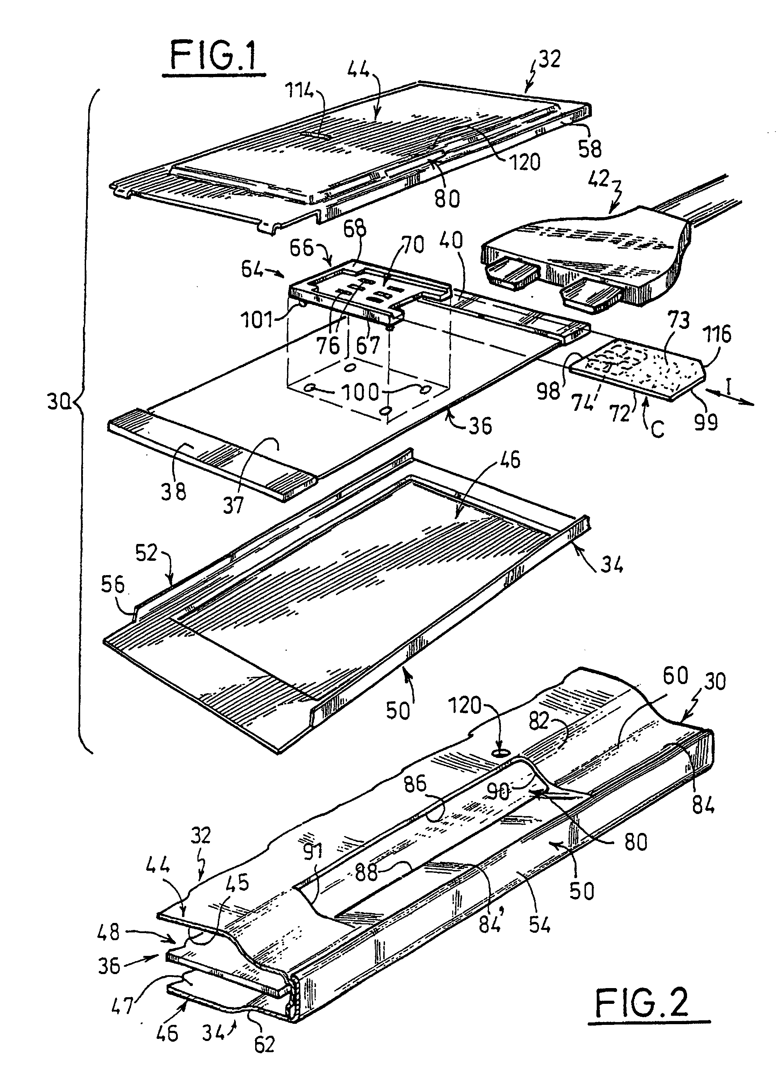

On a représenté à la figure 1 un boîtier de raccordement 30, de conception générale connue, qui est essentiellement constitué par une coquille métallique comportant une demi-coquille supérieure 32 et une demi-coquille inférieure 34 dont chacune est une pièce en tôle découpée, emboutie et pliée.

Les formes et les dimensions de la coquille en deux parties 32, 34 sont conformes à la norme PCMCIA qui, outre ses dimensions, détermine aussi les détails de conformation de la coquille de manière à permettre son introduction dans une fente normalisée (non représentée) de forme complémentaire appartenant par exemple à un ordinateur personnel.

A l'intérieur du boîtier 30, entre les demi-coquilles 32 et 34, est agencé une plaque à circuit imprimé 36 qui s'étend parallèlement au plan général du boîtier et qui porte, à chacune de ses extrémités longitudinales opposées, des connecteurs 38, 40, illustrés de manière schématique sur la figure 1, l'un ou l'autre des connecteurs pouvant, selon les applications, être remplacé par un élément de même dimension constituant un bouchon de fermeture du boîtier 30 à son extrémité longitudinale correspondante.

La plaque à circuit imprimé qui constitue la plaque intermédiaire du boîtier peut recevoir, sur ses deux faces, des composants électroniques (non représentés).

Comme on l'a représenté sur la figure 1, l'un des connecteurs 40 peut par exemple être conçu pour permettre le branchement d'une prise 42 qui assure le raccordement du boîtier 30 par exemple avec une ligne de télécommunication.

La demi-coquille supérieure 32 délimite une paroi principale supérieure plane 44 qui, en coopération avec la paroi principale inférieure plane 46 de la demi-coquille inférieure 34, délimite une cavité interne 48 (voir figure 2) à l'intérieur de laquelle s'étend la plaque à circuit imprimé 36, parallèlement aux parois 44 et 46 et sensiblement à mi-hauteur entre les faces internes en vis-à-vis 45 et 47 des parois 44 et 46.

Selon la conception normalisée du boîtier 30, celui-ci est délimité transversalement par deux parois latérales opposées 50 et 52, qui sont parallèles à la direction générale longitudinale du boîtier 30 et qui sont ici constituées par des bords rabattus verticaux 54 et 56 de la demi-coquille inférieure 34 qui sont sertis autour des bords latéraux en vis-à-vis de la demi-coquille supérieure 32 dont l'un 58 est illustré à la figure 1.

Sans sortir du cadre de l'invention, le boîtier 30 peut être réalisé avec une coquille en une seule pièce.

Les parois latérales 50 et 52 du boîtier de raccordement 30 sont conformées en forme de rails de guidage du boîtier 30 dans des glissières correspondantes (non représentées) appartenant à la fente normalisée destinée à recevoir le boîtier 30.

A cet effet, les portions d'extrémité latérale des demi-coquilles supérieure 32 et inférieure 34 sont déformées 60, 62 pour conférer aux parois latérales 50 et 52 une hauteur réduite par rapport à la hauteur globale du boîtier 30, c'est-à-dire son épaisseur dans sa partie centrale.

Conformément à l'invention, un connecteur 64 destiné à recevoir une carte C à circuit(s) intégré(s) à contact du type "MICRO SIM" est agencé à l'intérieur du boîtier 30.

Selon une conception connue, qui est par exemple décrite et représentée dans la demande de brevet français No. 95.14767, le connecteur 64 est constitué pour l'essentiel par un support en matériau isolant 66 qui délimite dans sa face supérieure 68 un logement 70 de forme complémentaire de celui de la carte C et qui est destiné à recevoir au moins en partie cette dernière dont la face inférieure 72 comporte des plages conductrices 74 qui, lorsque la carte C est en position introduite dans le logement 70, sont en contact avec des extrémités de contact 76 appartenant à des lames de contact 78 du connecteur.

Conformément à ce mode de réalisation de l'invention, le connecteur 66 est prévu pour être monté avec la face inférieure 67 de l'isolant 66 en appui sur la face supérieure 37 de la plaque à circuit imprimé 36.

Une fois le boîtier 30 assemblé et fermé avec le connecteur 64 porté par la plaque à circuit imprimé 10 et afin de permettre l'introduction et ou l'extraction de la carte C dans le connecteur 64, il est prévu une fente 80 qui, dans le mode de réalisation préféré illustré aux figures, est agencée au voisinage de l'une des parois latérales 50 du boîtier de raccordement 30.

Plus particulièrement, et comme on peut le voir en détail sur la figure 2, la fente d'introduction 80 s'étend pour l'essentiel dans la portion inclinée 82 de la partie latérale de la demi-coquille supérieure 32 qui relie la paroi principale supérieure 44 au pli 60 qui s'étend dans la portion plane 84 correspondant à la portion latérale d'épaisseur réduite du boîtier 30.

La portion 84' de la partie 84, qui s'étend au droit de la fente 80 découpée dans la partie inclinée 82, est légèrement déformée verticalement vers le bas par rapport au plan général de la partie 84.

La fente d'introduction 80 est ainsi délimitée par deux bords principaux supérieurs 86 et 88 et par deux bords d'extrémité 90 et 92.

Dans cette conception préférée de la fente 80, celle-ci ne s'étend pas dans la paroi supérieure principale 44 et sa largeur mesurée selon la direction générale longitudinale du boîtier, est légèrement supérieure à la largeur de la carte C de manière à permettre l'introduction et l'extraction de cette dernière selon une direction I qui est transversale par rapport à la direction générale longitudinale du boîtier.

Selon le premier mode de réalisation, afin de permettre l'extraction de la carte C hors du boîtier 30, il est prévu dans la plaque principale supérieure 44 une entaille ou rainure d'extraction 114 qui s'étend transversalement par rapport au boîtier 30, c'est-à-dire parallèlement à la direction I d'introduction ou d'extraction de la carte. L'entaille 114 est positionnée de manière à s'étendre de part et d'autre du bord transversal arrière 98 de la carte C et, de préférence, en vis-à-vis d'une zone du connecteur 64 ne comportant pas de parties métalliques appartenant aux lames de contact 78.

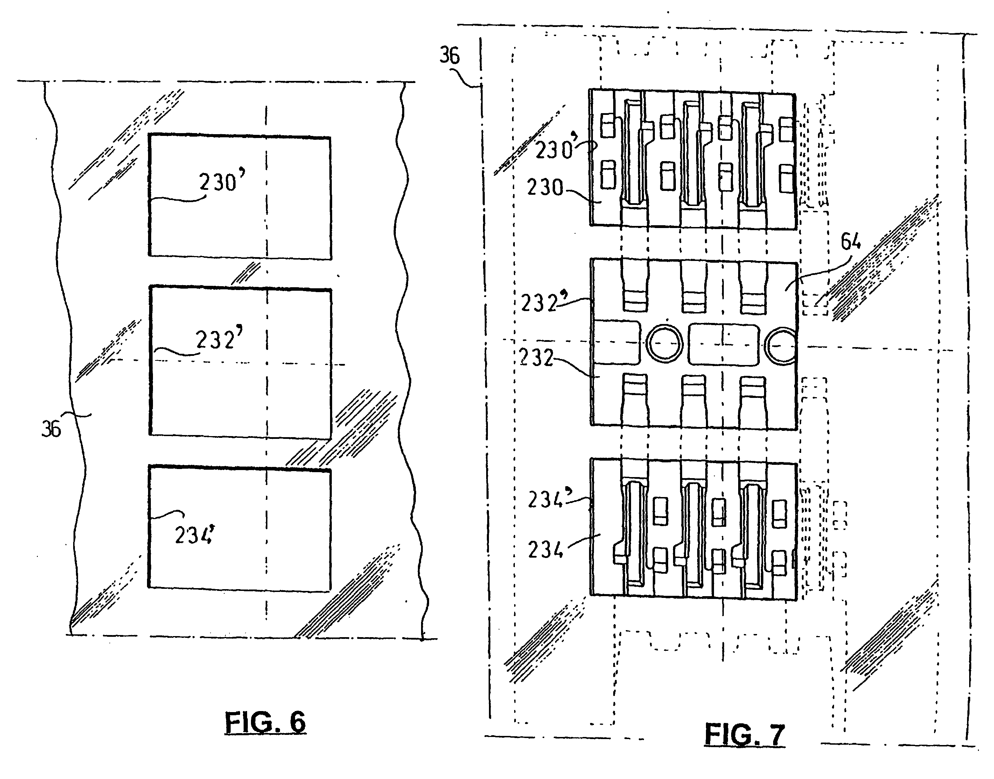

Ainsi, il est possible d'introduire un outil de petite dimension dans l'entaille 114 pour agir sur le bord transversal arrière 98 de la carte C afin de la repousser hors de son logement 70, c'est-à-dire en la faisant coulisser de la gauche vers la droite en considérant la figure 6, sur la course permise par la longueur de l'entaille 114 de manière que son bord transversal avant 99 sorte au moins en partie du boîtier 30 par la fente 80 de façon que, à l'issue de cette première phase d'extraction, l'utilisateur puisse attraper la carte pour l'extraire entièrement du boîtier 30.

Selon la définition normalisée des cartes "MICRO SIM", dont un exemple est illustré dans le cadre de la présente description, la carte C comporte au voisinage de son bord transversal avant 99 un pan coupé 116 qui, pour certaines applications, constitue un moyen de détrompage de la position de la carte C dans son connecteur.

Afin de maintenir la carte C en position introduite dans le boîtier 30 et éviter son échappement accidentel hors du boîtier, même partiel, il peut être prévu un bossage 120 formé dans la paroi principal supérieure 44 au droit du pan coupé 116 et qui s'étend, sur une faible hauteur, à l'intérieur de la cavité 48, pour constituer une butée qui s'étend en regard du pan coupé 116.

Lors de l'extraction de la carte au moyen d'un outil introduit dans l'entaille 114, l'utilisateur doit appliquer un effort légèrement plus important de manière que, par une légère déformation élastique de la partie correspondante de la paroi supérieure 44, la butée constituée par le bossage 120 s'efface lors du passage du pan coupé 116 puis de la face supérieure 73 de la carte C.

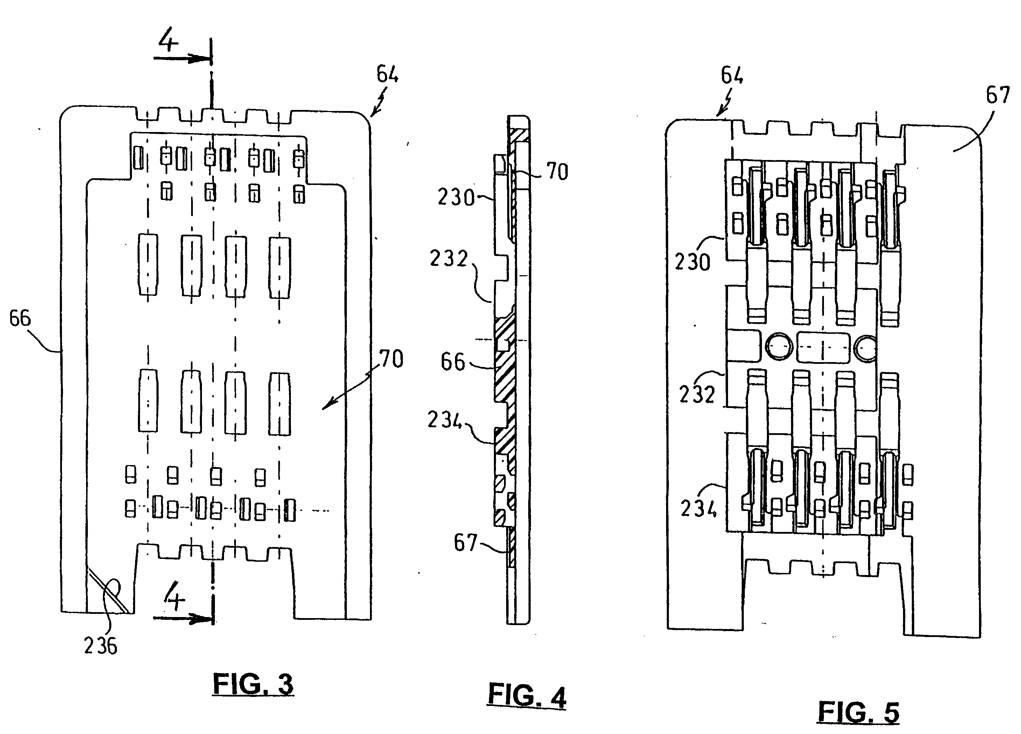

On décrira maintenant la variante de réalisation de l'isolant du connecteur 64 illustré aux figures 3 à 5 qui est prévu pour être monté en association avec une plaque à circuit imprimé 36 modifiée de manière complémentaire et qui est illustrée partiellement aux figures 6 et 7.

Dans ce mode de réalisation, le connecteur 64 présente une partie supérieure, c'est-à-dire qui est prévue pour s'étendre au-dessus de la face supérieure 37 de la plaque à circuit imprimé 36, qui est d'épaisseur réduite par rapport aux modes de réalisation décrits précédemment.

A cet effet, une partie du corps de l'isolant 66 s'étend en-dessous de la face inférieure 67 qui prend appui sur la face supérieure 37 de la plaque à circuit imprimé 36, cette partie inférieure étant constituée par trois pavés de contour rectangulaire 230, 232 et 234 dont chacun est prévu pour s'étendre dans une ouverture de forme complémentaire 230', 232', 234', respectivement, agencée dans la plaque 36.

Les pavés 230 et 234 reçoivent les moyens de rétention des contacts et le pavé central 232 permet le débattement des parties de contact 78 déformables.

Grâce à une telle conception, le connecteur 64 peut notamment être agencé sur l'une ou l'autre des faces opposées de la plaque à circuit imprimé 36, c'est-à-dire tant dans la moitié supérieure de la cavité 48 partagée en deux par la plaque à circuit imprimé 36 que dans sa moitié inférieure qui dans certains cas est d'une hauteur réduite, c'est-à-dire qu'elle partage la cavité en deux parties de hauteurs inégales.

Le positionnement du connecteur 64 par rapport à la plaque à circuit imprimé 36 est alors assuré par les pavés 230, 232 et 234. Pour la fonction d'entretoise, l'un des pavés peut comporter des pieds formant entretoise.

## Revendications

1. Boîtier (30) de raccordement électronique, notamment pour un ordinateur individuel, en forme générale de carte du type comportant une coquille (32, 34) à parois principales planes parallèles et opposées (44, 46), supérieure et inférieure , qui délimitent entre elles une cavité (48), ouverte à ses deux extrémités longitudinales opposées et délimitée transversalement par deux parois latérales opposées (50) conformées en forme de rails de guidage du boîtier, et à l'intérieur de laquelle est agencée une plaque intermédiaire (36), notamment une plaque à circuit imprimé, qui s'étend sensiblement à mi-hauteur entre les faces internes en vis à vis (45, 47) des parois principales et parallèlement à ces dernières, et le boîtier (30) contenant un connecteur (64), pour relier électriquement au boîtier une carte à circuit(s) intégré(s) à contact (C), qui comporte un support (66) en matériau isolant agencé sur la face supérieure (37) de la plaque intermédiaire (36), la coquille (32) comportant une fente (80) pour l'introduction, ou l'extraction, de la carte (C) dans le boîtier selon une direction (I) sensiblement parallèle au plan de la carte (C), de manière que, en position introduite, la carte (C) soit agencée entièrement à l'intérieur du boîtier (30),
**caractérisé en ce que** le connecteur (64) présente une partie supérieure d'épaisseur réduite prévue pour s'étendre au-dessus de la face supérieure (37) de la plaque intermédiaire (36) et pour recevoir la carte (C), et **en ce qu'**une partie inférieure du corps du support isolant (66) s'étend en dessous de la face inférieure (67) du connecteur qui prend appui sur la face supérieure (37) de la plaque (36), cette partie inférieure étant constituée par des pavés (230, 232, 234) dont chacun est prévu pour s'étendre dans une ouverture (230', 232', 234') de forme complémentaire agencée dans la plaque (36), lesdits pavés comprenant an moins une partie des éléments de contact électrique du connecteur destinés à entrer en contact avec des plages conductrices (74) de la carte (C).

2. Boîtier de raccordement selon la revendication précédente, **caractérisé en ce que** lesdits pavés (230, 232, 234) sont au nombre de trois et sont de contour rectangulaire.

3. Boîtier de raccordement selon l'une des revendications 1 ou 2, **caractérisé en ce que** le support en matériau isolant (66) comporte un logement (70) ouvert dans sa face supérieure (68), délimité par deux bords (92, 94) parallèles à la direction d'introduction de la carte et transversalement par au moins un bord arrière (96) et qui reçoit au moins en partie la carte (C) comportant sur sa face principale inférieure (72) lesdites plages conductrices (74) qui coopèrent avec les extrémités de contact (76) desdits éléments (78) de contact électrique, agencées dans le fond du logement (70) du support, lorsque la carte (C) est dans sa position de raccordement dans laquelle son bord transversal arrière (98) est en butée contre le bord transversal arrière (96) du logement, et **en ce que** la face interne en vis à vis (45) de la paroi principale supérieure (44) est adjacente à la face supérieure (68) du support (66) du connecteur (64).

4. Boîtier de raccordement selon l'une quelconque des revendications précédentes, **caractérisé en ce que** la direction (I) d'introduction de la carte (C) dans le boîtier (30) est perpendiculaire à la direction longitudinale du boîtier, et **en ce que** la fente d'introduction (80) est formée au moins en partie dans l'une des parois latérales (50) du boîtier.

5. Boîtier de raccordement selon l'une quelconque des revendications précédentes, **caractérisé en ce qu'**il comporte des moyens d'extraction de la carte hors du boîtier.

6. Boîtier de raccordement selon la revendication 5 prise en combinaison avec la revendication 3, **caractérisé en ce que** les moyens d'extraction de la carte (C) comportent une entaille (114) formée dans la paroi principale supérieure (44) du boîtier (30) et qui s'étend parallèlement à la direction (I) d'introduction pour permettre d'agir sur la carte (C) en vue de provoquer son coulissement à l'intérieur du logement (70) dans le sens correspondant à son extraction.

7. Boîtier de raccordement selon la revendication 6, **caractérisé en ce que** l'entaille (114) s'étend au moins en partie au droit du bord transversal arrière (98) de la carte (C) lorsque cette dernière est en position introduite pour permettre l'introduction d'un outil d'extraction qui coopère avec le bord transversal arrière de la carte.

## Patentansprüche

1. Elektronisches Verbindungsgehäuse (30), insbesondere für einen Personalcomputer, in allgemeiner Form einer Karte vom Typ mit einer Schale (32, 34) welche flache, parallele und einander gegenüberliegend angeordnete obere und untere Hauptwände (44, 46) besitzt, die zwischen ihnen einen Hohlraum (48) begrenzen, der an seinen beiden gegenüberliegenden Längsenden offen ist und in Querrichtung durch zwei seitliche gegenüberliegende Wände (50) begrenzt ist, die in Form von Schienen zur Führung des Gehäuses ausgebildet sind, wobei in dessen Innenraum eine Zwischenplatte (36) angeordnet ist, insbesondere eine Platte mit gedruckter Schaltung. die sich im wesentlichen auf halber Höhe zwischen den Innenflächen (45, 47) in Gegenüberstellung zu den Hauptwänden und parallel zu diesen erstreckt, und wobei das Gehäuse (30) einen Verbinder (64) enthält, um mit dem Gehäuse eine Kontaktkarte (C) mit integriertem(n) Schaltkreis(en) elektrisch zu verbinden, die einen Träger (66) aus isolierendem Material, welcher auf der Oberseite (37) der Zwischenplatte (36) angeordnet ist, umfasst, welche Schale (32) einen Schlitz (80) zum Einführen, oder Herausziehen, der Karte (C) in das Gehäuse in einer zur Ebene der Karte (C) im wesentlichen parallelen Richtung (I) aufweist, derart, dass die Karte (C) in eingeführter Position gänzlich im Innern des Gehäuses (30) angeordnet ist, **dadurch gekennzeichnet, dass** der Verbinder (64) einen oberen Teil mit verminderter Dicke aufweist, welcher sich auf der Oberseite (37) der Zwischenplatte (36) erstreckt und die Karte (C) aufnehmen soll, und dass sich ein unterer Teil des Rumpfes des Isolierträgers (66) unterhalb der Unterseite (67) des Verbinders erstreckt, welcher zur Anlage auf der Oberseite (37) der Platte (36) gelangt. wobei dieser unterer Teil durch Blöcke (230,232,234) gebildet ist, von denen sich jeder in einer in der Platte (36) angeordneten Aufnahme (230', 232', 234') mit komplementärer Form erstrecken soll, wobei die Blöcke wenigstens einen Teil der elektrischen Kontaktelemente des Verbinders aufweisen soll, die in Kontakt mit den leitfahigen Bereichen (74) der Karte (C) kommen sollen.

2. Verbindungsgehäuse nach dem vorhergehenden Anspruch, **dadurch gekennzeichnet. dass** die Blöcke (230, 232, 234) in einer Anzahl von drei vorliegen und eine rechtwinklige Kontur haben.

3. Verbindungsgehäuse nach einem der Ansprüche 1 oder 2, **dadurch gekennzeichnet, dass** der Träger aus isolierendem Material (66) in seiner Oberfläche (68) einen offenen Sitz (70) aufweist, welcher von zwei zur Einfügerichtung der Karte parallelen Rändern (92, 94) und in Querrichtung durch wenigstens einen Hinterrand (96) begrenzt ist, und welcher wenigstens teilweise die Karte (C) aufnimmt, welche auf ihrer unteren Hauptseite (72) die leitfähigen Bereiche (74) aufweist, die mit den Kontaktenden der elektrischen Kontaktelemente (78) zusammenwirken, welche in dem Boden des Sitzes (70) des Trägers angeordnet sind, wenn die Karte (C) in ihrer Verbindungsposition ist, in welcher ihr hinterer Querrand (98) dem hinteren Querrand (96) des Sitzes anliegt, und dass die der oberen Hauptwand (44) gegenüberliegende Innenseite (45) der Oberseite (68) des Trägers (66) des Verbinders (64) angrenzt.

4. Verbindungsgehäuse nach einem der vorhergehenden Ansprüche, **dadurch gekennzeichnet, dass** die Einführrichtung (I) der Karte (C) in das Gehäuse (30) senkrecht zur Längsrichtung des Gehäuses ist, und dass der Einführschlitz (80) wenigstens zum Teil in einer der Seitenwände (50) des Gehäuses ausgebildet ist.

5. Verbindungsgehäuse nach einem der vorhergehenden Ansprüche, **dadurch gekennzeichnet, dass** es Mittel zum Herausziehen der Karte aus dem Gehäuse umfasst.

6. Verbindungsgehäuse nach Anspruch 5 in Kombination mit Anspruch 3, **dadurch gekennzeichnet, dass** die Mittel zum Herausziehen der Karte (C) einen Schlitz (114) umfassen, der in der oberen Hauptwand (44) des Gehäuses (30) ausgebildet, ist und sich parallel zur Einführrichtung (I) erstreckt, um auf die Karte (C) so einwirken zu können, dass sie im Innern des Sitzes (70) in der Richtung, welche ihrem Herausziehen entspricht, verschoben werden kann.

7. Verbindungsgehäuse nach Anspruch 6. **dadurch gekennzeichnet, dass** sich der Schlitz (114) wenigstens teilweise in der Flucht des hinteren Querrands (98) der Karte (C) erstreckt, wenn die letztere in eingeführter Position ist, um das Einführen eines mit dem hinteren Querrand der Karte zusammenwirkenden Herausziehwerkzeugs zu ermöglichen.

## Claims

1. Electronic connection unit (30), in particular for a personal computer, in the general form of a card of the type comprising a shell (32, 34) with upper and lower parallel and opposite plane main walls (44, 46) which, between them, delimit a cavity (48) which is open at its two opposite longitudinal ends and is transversely delimited by two opposite side walls (50), designed in the form of guide rails for the unit, and inside which cavity an intermediate board (36), in particular a printed-circuit board, is arranged which extends substantially halfway between the opposite inner faces (45, 47) of the main walls, and parallel to the latter, and the unit (30) including a connector (64) for electrically connecting a contact card (C) with integrated circuit(s) which includes a support (66) made of insulating material arranged on the upper face (37) of the intermediate board (36), the shell (32) having a slot (80) for insertion or extraction of the card (C) into or from the unit in a direction (I) substantially parallel to the plane of the card (C), so that, when inserted, the card (C) is arranged entirely inside the unit (30),
**characterised in that** the connector (64) has an upper part of reduced thickness, intended to extend above the upper face (37) of the intermediate board (36) and to receive the card (C), and **in that** a lower part of the insulating support (66) extends below the lower face (67) of the connector which bears on the upper face (37) of the board (36), this lower part consisting of blocks (230, 232, 234), each of which is intended to extend into a complementarily shaped opening (230', 232', 234') arranged in the board (36), said blocks comprising at least a part of the electrical contact elements of the connector intended to come into contact with the conductive zones (74) of the card (C).

2. Connection unit according to claim 1, **characterised in that** said blocks (230, 232, 234) are three and they have a rectangular contour.

3. Connection unit according to Claim 1 or 2, **characterised in that** the support (66) made of insulating material includes an open housing (70) in its upper face (68), delimited by two edges (92, 94), parallel to the insertion direction of the card, and transversely by at least one rear edge (96), and which at least partly receives the card (C) including, on its lower main face (72), said conductive zones (74) which interact with the contact ends (76) of said electrical contact elements (78) arranged in the bottom of the housing (70) of the support, when the card (C) is in its connection position, in which its rear transverse edge (98) abuts against the rear transverse edge (96) of the housing, and **in that** the opposite inner face (45) of the upper main wall (44) is adjacent to the upper face (68) of the support (66) of the connector (64).

4. Connection unit according to any one of the preceding claims, **characterised in that** the direction (I) of insertion of the card (C) into the unit (30) is perpendicular to the longitudinal direction of the unit, and **in that** the insertion slot (80) is formed at least partly in one of the side walls (50) of the unit.

5. Connection unit according to any one of the preceding claims, **characterised in that** it includes means for extracting the card from the unit.

6. Connection unit according to Claim 5, taken in combination with Claim 3, **characterised in that** the means for extracting the card (C) include a notch (114) which is formed in the upper main wall (44) of the unit (30) and extends parallel to the insertion direction (I) in order to make it possible to act on the card (C) with a view to causing it to slide inside the housing (70) in the direction corresponding to its extraction.

7. Connection unit according to Claim 6, **characterised in that** the notch (114) extends at least partly in line with the rear transverse edge (98) of the card (C), when the latter is in the inserted position, in order to allow the insertion of an extraction tool which interacts with the rear transverse edge of the card.
